# EUROPÄISCHE PATENTSCHRIFT

(11) **EP 0 703 646 B1**
(45) Veröffentlichungstag und Bekanntmachung des Hinweises auf die Patenterteilung: **16.06.1999**
(21) Anmeldenummer: 95113670.4
(22) Anmeldetag: 31.08.1995
(51) Int. Cl.: H01R 43/26, H05K 13/06

(54) **Verfahren und Vorrichtung zum Verdrahten von Anschlussstellen von Komponenten elektrischer Geräte**
Process and device for wiring the terminals of components of electrical apparatus
Procédé et dispositif pour câbler les bornes de raccordement de composants d'appareils électriques

(30) Priorität: 02.09.1994 DE 4431254
(43) Veröffentlichungstag der Anmeldung: 27.03.1996
(73) Patentinhaber: Brökelmann, Jaeger & Busse GmbH & Co, D-59755 Arnsberg (DE)
(72) Erfinder: Tennie, Heinrich, D-59755 Arnsberg (DE); Kämper, Karl Friedrich, D-51702 Bergneustadt (DE); Baumeister, Olaf, D-59846 Sundern-Hövel (DE)
(74) Vertreter: Patentanwälte Ostriga & Sonnet

(56) Entgegenhaltungen:
- EP-A- 0 365 137
- EP-A- 0 573 791
- GB-A- 2 265 560
- US-A- 4 091 515

## Beschreibung

Die Erfindung betrifft ein Verfahren und eine Vorrichtung zum Verdrahten von Anschlußstellen von Komponenten elektrischer Geräte.

Insbesondere ist daran gedacht, ein Verfahren und eine Vorrichtung anzugeben, mit der aufwendiger verkabelte Leuchten wie Leuchtstoffleuchten automatisch verdrahtet werden können.

Aus der DE 36 08 243 ist es allgemein bekannt, Kabelbäume mit Hilfe eines Industrierobotors herzustellen, den eine elektronische Steuereinheit steuert, in die einzelne Verfahrensschritte eingebbar sind. Der Roboter verwendet dabei off-line programmierte Daten der Kabelbaum-Geometrie, um das oder die Kabel 'baumgerecht' zu verlegen, wobei der Roboter wechselweise Greif- und Verlegewerkzeuge erfaßt und bewegt. Die am Kabelbaum anzuschließenden Steckergehäuse umfassen Schneidklemmverbinder, an die ein vom Roboter ergriffenes Montagewerkzeug die Kabel anschließt.

Weiterhin ist es z.B. aus der DE-AS 1 050 855 bekannt, vormontierte Gerätekomponenten mittels einer gesteuerten Maschine zu verdrahten, wobei zwei längs X-und Y-Koordinaten verfahrbare Verdrahtungswerkzeuge vorgesehen sind, welche von einer gemeinsamen Drahtzuführungsvorrichtung mit Drahtstücken versorgt werden und welche nach Zuführen der Drähte nach einem besonderen Verdrahtungsprogramm deren Überführung in die Arbeitsstellung an den vorbestimmten Anschlüssen bewirken. Die Montage der Drähte an den vorbestimmten Anschlüsse erfolgt mittels 'wire-wrap'-Technik. Das Verdrahtungsverfahren nach dieser DE-AS 1 050 855 ist insbesondere wegen der Notwendigkeit zweier Verdrahtungswerkzeuge aufwendig und im Hinblick auf die Konfektionierung von einzelnen Drähten auch umständlich, zumal, wenn isolierte Drähte verarbeitet werden, die dann jeweils an ihren beiden Enden abisoliert werden müssen.

Auch die DE 35 06 797 befaßt sich mit einem Verfahren zur Verlegung von elektrischen Leitern in einem Verdrahtungsfeld. Die Anschlußelemente sind hier ebenfalls als Schneidklemmkontakte ausgebildet, die als Besonderheit einen dem Schneidklemmbereich vorgelagerten Klemmbereich aufweisen. Die Drähte werden zunächst mit ihrer Isolation in den Klemmbereichen lediglich klemmend festgelegt und erst nach der Verlegung des ganzen Drahtabschnitts bzw. aller Drähte innerhalb des Verdrahtungsfeldes gleichzeitig oder sukzessiv in die Schneidklemmbereiche des Verdrahtungsfeldes überführt. Hier besteht insbesondere der Nachteil, daß das Arbeitswerkzeug jede Anschlußstelle zweimal anfahren muß.

Die US-PS 4 129 349 beschreibt ein Verfahren zur Leitungsverlegung, bei dem der auf einer Trommel gelagerte Drahtvorrat nicht stückweise, sondern endlos verarbeitet wird. Dazu ist ein von Hand zu führendes Verlegewerkzeug vorgesehen, das eine Durchlauf-Führung für den Draht, einen Stempel zum Eindrücken des Drahtes in die als Schneidklemmen ausgestalteten Anschlußstellen und ein verschiebbar gelagertes Messer zum bedarfsweisen Abschneiden des Drahtes aufweist. Ein vergleichbares Verfahren ist auch Gegenstand der US-PS 3 930 524, dessen allerdings nicht über einen Eindrückstempel verfügendes Draht-Verlegwerkzeug bereits mechanisch gesteuert und mittels eines Kreuzschlittens über die Verdrahtungszone verfahrbar ist.

Dieser nur bruchstückhafte Ausschnitt aus dem recht umfangreichen Stand der Technik zur automatischen Verdrahtung von elektrischen Bauteilen zeigt, daß nach wohl vorherrschender Meinung befriedigende Ergebnisse nur dann erzielt werden konnten, wenn das Verfahren und die Vorrichtung zum Leiteranschluß an Schneidklemmkontakten ausgelegt sind. Selbst die junge DE-42 18 741 A1 greift diese teils alten Gedanken wieder auf und schlägt beispielhaft für eine Leuchtenkonfektionierung ein automatisches Verdrahtungsverfahren vor, welches im Prinzip darin besteht, das aus der US-PS 4 129 349 als Handgerät bekannte Verlegewerkzeug mit Drahtführung, Stempel und Messer entsprechend dem bereits in der DE 36 08 243 enthaltenen Vorschlag mittels computergesteuertem Industrieroboter zu führen und die in der bekannten Art und Weise in die Anschlußstellen verbrachten Drähte berührungssicher darin aufzubewahren. Die berührungssichere Aufbewahrung von Drahtenden in Schneidklemmkontakten ist andererseits bereits ausdrücklich in der DE 32 36 868 A1 angesprochen, die die Gestaltung einer elektrischen Edison-Glühlampenfassung behandelt.

Die Erfinder haben erkannt, daß man die vermeintlichen Vorteile der automatischen Verdrahtung mittels Kontakten in Schneidklemmtechnik durch einen immensen konstruktiven Aufwand bei den Geräteteilen und Bauelementen erkaufen muß, an denen die Verdrahtung angebracht wird. Während beispielsweise Leuchtstoffleuchten konventionell durchweg mit Geräten und Bauelementen ausgerüstet sind, deren Kontakte als schraubenlose Anschlußklemmen ausgeführt sind, in die abisolierte Leiterenden in Leiterlängsrichtung eingesteckt werden, müssen diese sämtlichen Geräte und Komponenten in Anpassung an die Schneidklemmtechnik vollkommen neu entwickelt, von Grund auf konstruiert und gesondert gefertigt werden. Keineswegs vermögen diese Geräte die herkömmlichen generell zu ersetzen, so daß der Bauelement- und ggf. auch der Gerätehersteller praktisch zwei völlig gesonderte Produktlinien fahren müssen. Ist die Schneidklemmtechnik - wie aus der Mikroelektronik geläufig - insbesondere für vollautomatische Montage bzw. Bestückung ausgelegt, ist sie demgegenüber für Handmontage, insbesondere ohne Spezialwerkzeuge, wenig geeignet. Daraus resultiert, daß ein Interesse an 'automatischer Schneidklemm-Verdrahtung' allenfalls für neue Produktkonzeptionen, etwa also für neue, in großer Stückzahl aufzulegende Leuchtenserien, geweckt werden kann. Selbst dann aber bleibt der Mangel, daß sichere Handverdrahtungen, wie sie beispielsweise im Fall einer erforderlichen Reparatur an einem Anschluß notwendig werden oder bei geringen Stückzahlen zweckmäßig erscheinen, oder bei für Roboter unzugänglichen Anschlußstellen z.B. in Leuchten praktisch kaum mehr möglich sind, denn dazu eignet sich die Schneidklemmtechnik nicht.

Hiervon ausgehend, liegt der vorliegenden Erfindung die Aufgabe zugrunde, ein Konzept zur automatischen Verdrahtung von Baugruppen, Komponenten, Geräten od. dgl. anzugeben, deren Anschlußstellen übliche schraubenlose Anschlußklemmen aufweisen, also solche, die für einfache Einschubkontaktierung abisolierter Leiterenden in Leiterlängsrichtung ausgelegt sind. In diesem Fall könnten nämlich alle Baugruppen, Komponenten, Geräte wie beispielsweise Anschluß-, Vorschaltgeräte-, Kondensatorklemmen, Lampenfassungen od.dgl. in der altbekannten und milliardenfach bewährten Bauform ohne Anpassung an die Drahtverlege- und -anschlußtechnik weiterverwendet werden, wobei es zudem überhaupt keine Unterscheidung erfordert, ob diese Elemente vom Kunden nun zur manuellen oder automatischen Verdrahtung verwendet werden.

Insbesondere besteht also das Ziel der Erfindung in Abkehr von der DE 42 18 741 A1 darin, den vorhandenen Komponenten eine automatische Verdrahtung 'auf den Leib zu schneidern' und nicht darin, für ein vermeintlich eleganteres Verdrahtungsverfahren alle Anschlußstellen und die sie aufnehmenden Komponenten neu zu konzipieren.

Das Verfahren, das diese Aufgabe löst, ist in seinem Grundprinzip im unabhängigen Anspruch 1 angegeben. Die vorrichtungsgemäße Prinziplösung ist Gegenstand des unabhängigen Anspruches 9. Auf weitere vorteilhafte Ausbildungen und Gestaltungen beziehen sich die Unteransprüche 2 bis 8 und 10 bis 18.

Besonders wesentlich im Sinne der Erfindung ist, daß die von einem großen Vorrat, also praktisch 'endlos', verarbeitete Leitung mit in Intervallen von ihrer Isolierumhüllung freigeschnittenen, in der Regel unterschiedlichen, Abständen den Leitungsverlegemitteln zugeführt wird. Selbstverständlich entsprechen diese Intervalle bzw. Abstände solcher freigeschnittenen Leitungsbereiche voneinander dem jeweiligen späteren Verlegeabstand des entsprechenden Leitungsabschnitts innerhalb des elektrischen Geräts.

Das Verfahren zeichnet sich weiterhin dadurch aus, daß es die Gesamtverdrahtung eines Gerätes in - vom Weg und der Verlegerichtung verschiedenen, ansonsten aber wiederkehrenden - gleichartigen Schritten ausführt, die im wesentlichen darin bestehen, ein erstes abisoliertes Leiterende in eine erste Anschlußstelle zu stecken, sodann das Leitungsverlegemittel und eine zweite Anschlußstelle einander anzunähern, wobei eine im wesentlichen dem Verlegeweg entsprechende Leitungslänge gespendet wird, bis die entsprechende abisolierte Leitungszone in den Arbeitsbereich der Leitungsverlegemittel gelangt. Hier nun erfolgt ein Trennschnitt der Leitung in einem freigeschnittenen (abisolierten) Leitungsbereich, so daß ein zweites Leiteranschlußende geschaffen ist, welches das zweite Ende des bereits an einer Anschlußstelle befindlichen Leitungsabschnittes für eine zweite Anschlußstelle bereitstellt, der es zugeführt werden kann. Mit dem Trennschnitt wird zugleich ein weiteres erstes abisoliertes Steckende bereitgestellt zum Anschluß an eine dritte Anschlußstelle. Ist die diesbezügliche elektrische und mechanische Verbindung hergestellt nach dem Einstecken des abisolierten Endes in diese Anschlußstelle, fahren die Leitungsverlegemittel zur vierten Anschlußstelle. Kurz vor deren Erreichen wird wieder die Leitung durchtrenn zur Bildung eines zweiten Leitungsabschnittes mit abisoliertem Steckende für die Kontaktierung der vierten Anschlußstelle unter gleichzeitiger Erzeugung eines ersten Leitereinsteckendes für die fünfte Anschlußstelle usw.

Demzufolge besteht ein wesentliches Prinzip der Erfindung also darin, von einem großen Leitungsvorrat ausgehend diesen in der jeweiligen späteren Verarbeitungslänge entsprechenden Abständen von seiner Isolierumhüllung freizuschneiden derart, daß bei mittigem Durchtrennen der entisolierten Zone gleichzeitig zwei Leitereinsteckenden geschaffen werden, die Ende eines und zugleich Anfang eines weiteren, mittels der Leitungsverlegemittel zu verlegenden und zu kontaktierenden Leitungsabschnittes darstellen. Das erste Ende eines solchen Leitungsabschnittes wird unmittelbar vom Endlosvorrat der Leitung erhalten, das zweite Ende nach Abtrennen von der zugeführten Leitung. Eine vollständige automatische Verdrahtung unterteilt sich also in untereinander prinzipiell gleichartige Einzelzyklen, wobei innerhalb eines Zyklus zwei bereitgestellte abisolierte Leiterenden den ihnen zugeordneten Anschlußstellen zugeführt werden.

Es werden jedoch keine vollständig in unterschiedlicher Länge vorkonfektionierten und an beiden Enden abisolierten Leitungsstücke von einer Handhabungsvorrichtung ergriffen und einzeln verarbeitet, sondern die benötigten Leitungsabschnitte werden am endlosen Leitungsvorrat selbst vorbereitet und mittels der Leitungsverlegemittel bei der Verlegung, also in deren Verlauf, zugleich endkonfektioniert.

Hiermit trägt die Erfindung in idealer Weise dem Umstand Rechnung, daß im Unterschied zur Schneidklemmtechnik bei der Leiter-Einstecktechnik abisolierte Leiterenden vorliegen müssen. Dies ist, der erfindungsgemäßen Lehre folgend, verfahrenstechnisch und apparativ jedoch ohne weiteres zu beherrschen, und der enorme Vorteil besteht, wie eingangs ausgeführt, eben darin, daß herkömmliche elektrische Komponenten mit den üblichen schraubenlosen Anschlußklemmen ohne jegliche spezialisierende Anpassung verwendbar sind.

Der vorrichtungsgemäße Kern der Erfindung entsprechend dem unabhängigen Anspruch 9 unterscheidet sich vom Stand der Technik insbesondere dadurch, daß das Manipulationsglied ein Greifer ist, kein Stößel oder Druckglied. Dieser Greifer erfaßt die Leitung stets nahe dem jeweiligen abisolierten Ende und steckt es in die jeweilige Anschlußstelle ein. Da der Greifer der Mündung der Leitungszuführung so zugeordnet ist, daß die Leitung selbsttätig zwischen die geöffneten Greiferbacken einführbar ist, ist es andererseits auch möglich, daß nach Vollendung eines Einsteckvorgangs und der dann während des weiteren Verlegewegs einsetzenden Förderung der Leitung der Greifer dem Verlegeweg der Leitung folgen kann, um sodann das zweite, nach dem Trennschnitt bereitgestellte Leiterende zu greifen und es in die nächsten Anschlußstelle einzustecken.

Im übrigen versteht man die Erfindung noch umfassender aufgrund der nachfolgenden Beschreibung einer Ausführungsform unter Bezugnahme auf die Zeichnungen. In diesen zeigen:
- Fig. 1: eine schematische Gesamtansicht einer zur Ausübung des automatischen Verdrahtungsverfahrens geeigneten Vorrichtung,
- Fig. 2: eine schematische Darstellung der Leitungsverlegemittel zur Beschreibung der Verdrahtung zweier Anschlußstellen bzw. Komponenten miteinander,
- Fig. 3: eine schaubildliche Darstellung zur Beschreibung der einzelnen Ablaufschritte während der Verdrahtung zweier Komponenten miteinander,
- Fig. 4: das untere bzw. vordere Arbeitsende der Leitungsverlegemittel in Seitenansicht und
- Fig. 5: das Manipulationsglied der Leitungsverlegemittel in einer Stirnansicht auf Fig. 4.

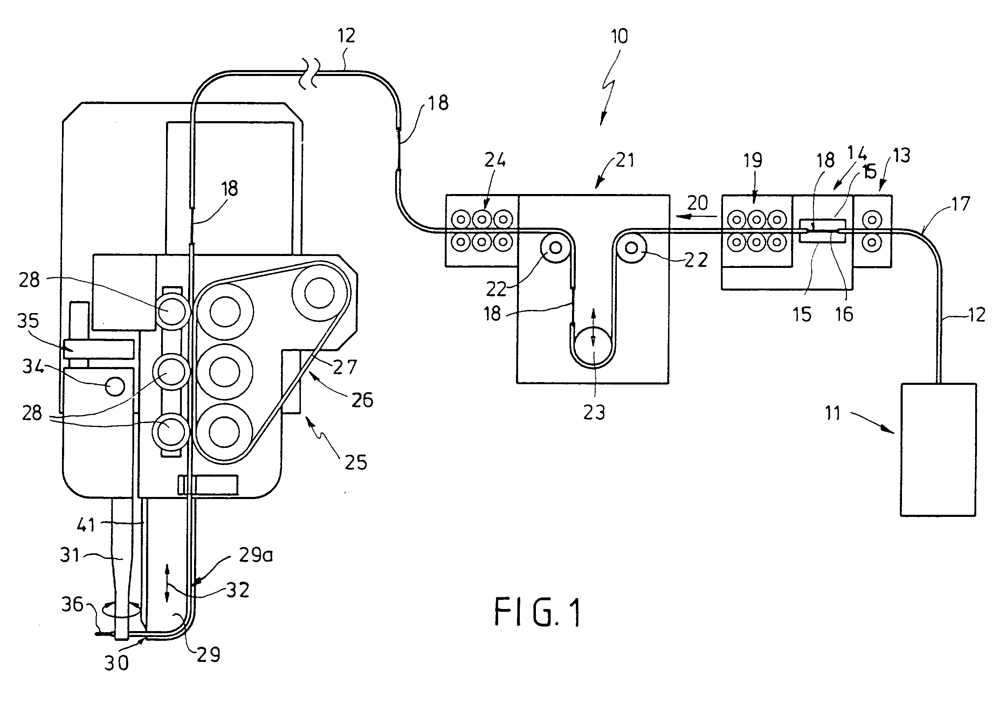

In Fig. 1 ist die Gesamtvorrichtung zum Verdrahten von Anschlußstellen von Komponenten elektrischer Geräte schematisch dargestellt und mit 10 bezeichnet.

Die Gesamtvorrichtung 10 umfaßt einen Vorrat 11 (sogenanntes "Leitungsfaß") für eine elektrische Leitung 12 - einem mit Isolierumhüllung versehenen knicksteifen Einzeldraht. Ausgehend vom Leitungsfaß 11 befindet sich im weiteren Verlauf der Leitung 12 ein Wegmeßsystem 13, dessen wesentliche Aufgabe darin besteht, die vorgegebenen Längen der in der Freischneidestation vorzubereitenden Leitungsabschnitte zu überwachen. Diese Freischneideinrichtung 14 ist hinter, d.h. 'stromabwärts' des Wegmeßsystems 13 vorgesehen und verfügt über Werkzeuge 15, denen die Aufgabe zufällt, an vorbestimmten Stellen, d.h. in vorprogrammierten Abständen, den Draht 16 von seiner Isolierumhüllung 17 zu befreien. Diese und andere im weiteren Leitungsverlauf in bedarfsentsprechend angepaßten Abständen freigeschnittenen, d.h. abisolierten Leitungszonen sind mit 18 bezeichnet.

Der Freischneideinrichtung 14 folgt ein erster Antrieb 19 zum Transport der Leitung 12 in Richtung des Pfeiles 20, dessen Zweck es ist, die Leitung 12 durch die Freischneideinrichtung 14 und vom Leitungsfaß 11 zu ziehen und umfaßt, wie beispielhaft angedeutet, als Antriebsmittel z.B. mehrere mittels Friktion an der Isolierumhüllung 17 der Leitung 12 angreifende, angetriebene Förderrollenpaare.

Sodann verläuft die Leitung 12 durch einen sogenannten Schlaufenheber 21, der einen Leitungsspeicher oder -kompensator darstellt und im Prinzip zwei an ortsfesten Achsen drehbar gelagerte Umlenkrollen 22 sowie eine denen gegenüber bewegliche Umlenk- bzw. Tänzerrolle 23 aufweist. Letztere belastet die ausgebildete Leitungsschlaufe, und je nach ihrer Stellung kann dem Antrieb 19 signalisiert werden, daß er die weitere Förderung von Leitung 12 verlangsamen, beschleunigen oder stoppen soll.

Der Leitungskompensator 21 entkoppelt den Antrieb 19 von einem dem Kompensator nachgeschalteten weiteren Leitungsantrieb 24, der prinzipiell wie der Antrieb 19 aufgebaut ist und die Leitung 12 in Förderrichtung beaufschlagt. Der Kompensator ermöglicht unterschiedliche Verarbeitungsgeschwindigkeiten (auch Stillstände) bei der Erzeugung der Leitungs-Freischneidungen 18 einerseits und der Leitungsverlegung mit Kontaktanschlüssen andererseits.

Vom Antrieb 24 gelangt die Leitung 12 schließlich zu den insgesamt mit 25 bezeichneten Leitungs-Verlegungsmitteln. Diese sind raumbeweglich am Ende eines nicht dargestellten, vorzugsweise sechsachsig raumbeweglichen Arms eines Industrieroboters angebracht. Den Leitungsverlegemitteln 25 ist ein weiterer Antrieb 26 zur Förderung der Leitung 12 zugeordnet, der ein umlaufend angetriebenes Förderband 27 umfaßt und mit nachgiebig gelagerten Gegendruckrollen 28 zusammenwirkt. Dieser dritte Antrieb 26 zum Transport der Leitung 12 ist mit dem zweiten Antrieb 24 derart synchronisiert, daß die Leitung 12 praktisch kräftefrei transportiert werden kann.

Die Leitungsverlegemittel 25 umfassen sodann eine Leitungszuführung 29, mit einem Kanal 29a, dessen Mündung mit 30 bezeichnet ist. Als Manipuliervorrichtung dient ein mit 31 bezeichneter Greifer, der die aus der Leitungszuführungs-Mündung 30 austretende und infolge geeigneter Krümmung des Kanals 29a unmittelbar zu ihm hingeführte Leitung 12 greifen kann.

Im übrigen ist die Anordnung so getroffen, daß die Leitungszuführung 29 relativ zum Greifer 31 verstellbar angeordnet ist, was mit dem Doppelpfeil 32 angedeutet ist. In der dargestellten Stellung befindet sich die Leitungszuführung 29 in ihrer einen (hier untersten) Endstellung in unmittelbarer Zuordnung zum Greifer 31. In der anderen Endstellung würde, bezogen auf Fig. 1, die Leitungszuführung 29 gegenüber dem Greifer nach oben verlagert sein.

Die den Leitungsverlegemitteln 25 zugeordnete Leitungstrennvorrichtung ist durch ein (bezgl. Fig. 1 vertikal) verschiebliches Messer 41 realisiert, das zwischen der Leitungszuführung 29, an dieser anliegend geführt, und dem Greifer 31 vorgesehen ist.

Schließlich ist noch zu erwähnen, daß der Greifer 31 um eine mit 34 bezeichnete Achse minimal schwenkbar ist, um - und zwar in beiden möglichen Schwenkrichtungen - mit einem Kraftaufnehmer 35 zusammenzuwirken, dessen Sinn und Zweck weiter unten erläutert wird.

Das der Erfindung zugrundeliegende Verfahren sowie die Arbeitsweise der in Fig. 1 dargestellten Vorrichtung in der oben beschriebenen Anordnung versteht sich nun wie folgt:

Es sei zunächst vorausgesetzt, daß das Leitungsfaß 11 mit einem neuen Leitungsvorrat bestückt wird und daß das vordere freie Ende der Leitung 12 abisoliert ist, so daß bereits ein erstes freies Leitereinsteckende 36 ausgebildet ist. Die Leitung 12 wird nun durch die einzelnen Stationen der Vorrichtung hindurchgeführt, wobei die Freischneideinrichtung 14 in einem ersten vorbestimmten Abschnitt vom freien Leiterende 36 die erste Zone an der Leitung freischneidet. In einem entsprechend den geräteseitigen Vorgaben berechneten weiteren Abstand von der ersten Zone der Freischneidung wird eine weitere Zone freigeschnitten und so fort. Die Länge eines jeden freigeschnittenen Drahtabschnitts 18 ist jeweils doppelt so groß wie die erforderliche Soll-Länge eines Leitereinsteckendes 36.

Im weiteren Verlauf einer ersten Maschinen-Einrichtung gelangt das führende Ende der Leitung 12 mit ihrem vorderen abisolierten Einsteckende 36 in die in Fig. 1 dargestellte Position, in der der Greifer 31 das Leitungsende mit geringem Abstand hinter dem Einsteckende 36 an der Isolierumhüllung faßt. Nun kann der Anschluß dieses Leitereinsteckendes 36 an die erste Anschlußstelle erfolgen.

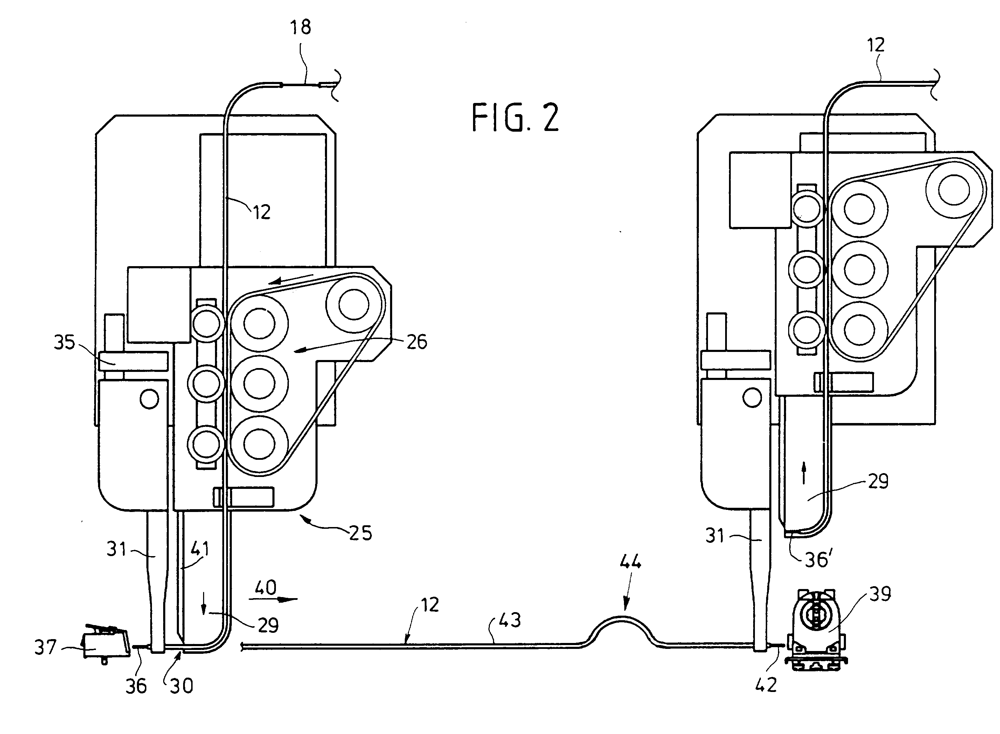

Dies geschieht unter Bezugnahme auf Fig. 2 dadurch, daß der Roboter programmgesteuert so bewegt wird, daß die Leitungsverlegemittel 25 mit dem Greifer 31 voran positionsgerecht einer mit Leitungsanschluß zu versehenden elektrischen Komponente 37 (hier beispielhaft als elektrische Netzanschlußklemme dargestellt) hingeführt werden und der Greifer 31 das Leitereinsteckende 36 in den schraubenlosen Kontakt dieser Komponente 37 einsteckt (Pfeil 38), womit elektrische und mechanische Verbindung gleichzeitig einhergehen.

Beim ordnungsgemäßen Einstecken des Einsteckendes 36 in die entsprechende Anschlußstelle der Komponente 37 entsteht eine Kraft, deren Größe in einem gewissen Rahmen bekannt ist. Die tatsächlich auftretende Kraft, die beim Einstecken des Leiterendes 36 ausgeübt wird, wird als Reaktionskraft auf den Greifer 31 und folglich auf den Druckaufnehmer 35 übertragen. Ist diese Kraft nun geringer als ein Soll-Schwellwert, muß davon ausgegangen werden, daß eine ordnungsgemäße elektrische Kontaktierung nicht möglich ist - es wird folglich ein Fehler gemeldet, bzw. die Maschinenarbeit gestoppt. Ein solcher Fall kann beispielsweise auftreten, wenn nach der Herstellung der Komponente 37 die Anschlußstelle nicht vorhanden ist, also kein Kontakt in das Gehäuse eingelegt wurde oder die Leiteraufnahme des Kontakts fehlerhaft geraten oder in die Komponente eingefügt worden ist. Denkbar ist auch, daß die Komponente fehlerhaft oder nicht am Gerät montiert worden ist, so daß das Leiterende die Anschlußstelle nicht finden kann. Wird andererseits ermittelt, daß die Einsteckkraft oberhalb eines oberen Schwellwertes liegt, muß ebenfalls davon ausgegangen werden, daß ein korrekter Anschluß des Leiterendes 36 unmöglich ist, weil, aus welchen Gründen auch immer, es seinen ordnungsgemäßen Weg in die Anschlußstelle nicht finden kann.

Für die weitere Beschreibung wird nun davon ausgegangen, daß der Greifer 31 das Einsteckende 36 in die zugeordnete Anschlußstelle der Komponente 37 eingegeben hat und der elektrische sowie mechanische Anschluß vollzogen ist. Jetzt wird kurzzeitig von den Verlegemitteln bzw. dem Roboterarm eine Zugprüfung in Richtung des Pfeiles 40 ausgeübt. Der noch geschlossene Greifer 31 trachtet folglich danach, den soeben vollzogenen Leiteranschluß wieder zu lösen. Die dabei auftretenden Leiterhaltekräfte werden vom Druckaufnehmer 35 gemessen und mit einem vorgegebenen Schwellwert verglichen. Unterschreitet die gemessene Auszugskraft einen vorgewählten Schwellwert, bedeutet dies in der Regel, daß die Haltekräfte in der Klemme nicht hinreichen für eine ordnungsgeäße elektrische und mechanische Verankerung des Leiterendes 36 in der Anschlußstelle der Komponente 37. Folglich wird auch in diesem Falle eine Fehlermeldung ausgegeben, evtl. die Maschine stillgesetzt, oder auch ein Fehlerprotokoll als Grundlage für eine spätere manuelle Nacharbeitung gespeichert.

Diese und die zuvor beschriebenen Montageerfolgs-Prüfung sind Feinheiten der Einrichtung, die in jedem Falle elektrische und mechanische Fehlanschlüsse am fertigen Gerät verhindern. Es ist allerdings davon auszugehen, daß solche Fälle selten sein werden, weil bei der Konfektionierung der elektrischen Komponenten 37, 39 selbst schon Prüfungen stattfinden, die fehlerhafte Anschlußstellen weitestgehend auszuschließen vermöge.

Im weiteren Verfahrensverlauf öffnet nun der Greifer 31, und die Verlegemittel 25 fahren, worauf der Pfeil 40 Bezug nimmt, zur nächsten Anschlußstelle bzw. Komponente 39 (hier als Beispiel eine Leuchtstofflampenfassung). Während dieses Verfahrens der Vorrichtung 25 längs dem vorbestimmten Leitungs-Verlegeweg wird vom Antrieb 26 eine der zurückgelegten Wegstrecke im wesentlichen entsprechende Länge an Leitung 12 nachgefördert. Kurz bevor die zweite Komponente 39 von den Verlegemitteln 25 erreicht ist, wird nach Schließen des Greifers 31 mittels des der Mündung 30 unmittelbar vorgeordneten gesteuerten Messers 41 die Leitung durchschnitten, und zwar möglichst exakt mittig in der jetzt zur Verarbeitung anstehenden freigeschnitten Zone 18. Auf diese Weise entsteht ein zweites abisoliertes Einsteckende 42 des noch in Bearbeitung befindlichen Leitungsstrangs 43 und gleichzeitig ein neues abisoliertes Ende 36' für den Verdrahtungsvorgang eines nachfolgenden Leitungsabschnitts.

Nach dem Durchtrennen wird die Leitungszuführung 29 - bezüglich Fig. 2 durch Verschieben nach oben - örtlich vom Greifer 31 entkoppelt, d.h. aus dem Arbeitsbereich des Greifers 31 herausgebracht, so daß dieser nun das abisolierte Einsteckende 42 in die dazu vorprogrammierte Anschlußstelle der Komponente 29 verbringen kann. Auch hier erfolgt die oben beschriebene Einsteck- und Haltekraftprüfung.

Da das beschriebene Durchtrennen der Leitung 12 vor dem Einstecken des abisolierten Leiterendes 42 mittels des Greifers 31 erfolgen muß, der Greifer 31 also danach noch ein Stück Weg zurücklegen muß, um das Leitereinsteckende 42 bestimmungsgemäß in der Komponente 391 zu plazieren, entspricht die geförderte Länge der Leitung nicht exakt den tatsächlich von der Vorrichtung 25 zurückgelegten Weg; vielmehr wird eine gewisse, mit 43 bezeichnete Überlänge gefördert, deren Länge ziemlich genau derjenigen Strecke entspricht, die der Greifer noch zurücklegen muß, um nach dem Durchtrennen der Leitung das abisolierte Ende 42 in die Anschlußstelle 39 zu überführen.

Ist dies geschehen, öffnet der Greifer 31, und die Leitungszuführung 29 wird wieder zur Übergabe des geschaffenen weiteren Leitungsendes in den Greiferbereich zurückgefahren und das Leiterende vorgeschoben, so daß sich dieselbe Ausgangsstellung für die folgende Verdrahtungsstrecke ergibt, wie sie anfangs hier vorgelegen hat.

Die beschriebenen Schritte vollziehen sich (abgesehen von den anfangs erläuterten Schritten zur Ersteinrichtung der Maschine mit neuem Leitungsvorrat) in jeweils der gleichen Art, um zwei Anschlußstellen unterschiedlicher Komponenten oder auch derselben Komponente anzufahren und die elektrische Leitung mit deren Anschlußstellen zu verbinden.

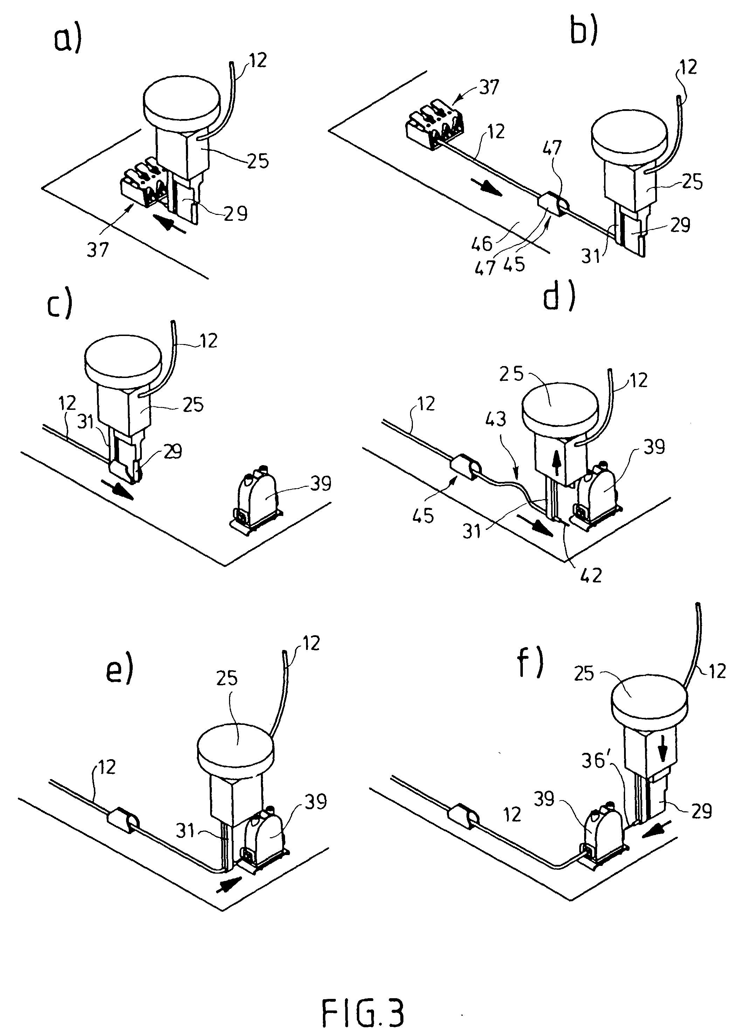

Wie schon kurz erwähnt, muß der Verlegeweg einer Leitung bzw. eines Leitungsabschnittes 43 nicht geradlinig sein. Selbst unmittelbar vor dem Anschluß eines Leiters 12 an eine Komponente 39 kann die Leitung 12 noch eine Abwinklung erfahren, wie Fig. 3 dies in den beiden unteren Darstellungen veranschaulicht.

Im Sinne einer 'ordentlichen' und auch ästhetischen Ansprüchen genügenden Leitungsverlegung sowie nicht zuletzt aus mechanischen und sicherheitstechnischen Gründen können auch Leitungshalter 45 an einem Geräteteil, wie z.B. hier am Bodenblech 46 eines Leuchtengehäuses, angebracht sein. Wie etwa Fig. 3 erkennen läßt, sind die Leitungshalter 45 im wesentlichen klammerartig ausgebildet und weisen zwei Federschenkel 47 auf, mit denen die Leitung 12 umschlossen werden kann, und zwar je nach Halter-Bauart lose oder auch klemmschlüssig. Für eine problemlose automatischen Verdrahtung ist es wichtig, daß die Leitungshalter 45 so beschaffen sind, daß die Leitung 12 führenden Verlegemittel 25, insbesondere die Vorderkante der Leitungszuführung 29, im Zuge der Leitungsverlegung zwischen die Federschenkel 27 eintreten und diese auseinanderspreizen können. Sobald der nachlaufende Greifer 31 den Leitungshalter 45 passiert hat, schließen sich die Federschenkel 27 wieder, und der Leitungshalter 45 schließt die durch ihn hindurchgeführte Leitung 12 ein.

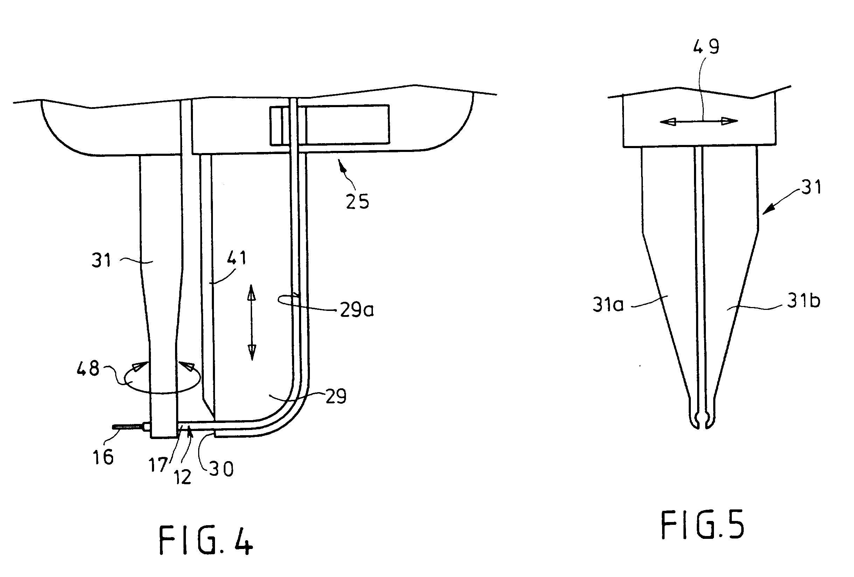

Mit Bezug auf Fig. 4 und 5 sei noch erwähnt, daß selbstverständlich die Verlegevorrichtung 25 um alle möglichen Raumachsen dreh- und schwenkbar angeordnet ist. Mit dem Doppelpfeil 48 ist in Fig. 4 schematisch die Drehbarkeit der Vorrichtung um eine zur Leiterachse im Bereich des Greifers 31 lotrechte Achse verdeutlich.

Schließlich ist noch zu erwähnen, daß der Greifer 31 zwei Greiferbacken 31a und 31b umfaßt, die öffenund schließbar sind, was der Doppelpfeil 49 in Fig. 5 veranschaulichen soll. Grundsätzlich sind Öffnungs- und Schließhub der Greiferbacken 31a und 31b so ausgelegt, daß sie entweder die Leitung 12 an ihrer Isolierumhüllung festklemmen oder völlig freigeben. Auch eine Zwischenstellung wäre denkbar, in der die Greiferbacken 31a und 31b nur teilgeöffnet werden, so daß zwar kein Klemmkontakt mehr erfolgt, die Leitung 12 aber auch nicht aus dem Greifer 31 herausfallen kann. Es ist jedoch bei der getroffenen Anordnung, die sich dadurch auszeichnet, daß der Greifer 31 der Mündung 30 der Leitungszuführung 29 sehr dicht vorgelagert ist, nicht zu befürchten, daß der Greifer 31 den Kontakt zur Leitung 12 jemals verlieren kann, zumal die Leitung 12 ja auch eine gewisse Eigensteifigkeit besitzt.

## Patentansprüche

1. Verfahren zum Verdrahten von Anschlußstellen elektrischer Komponenten mit Hilfe gesteuerter Leitungsverlegemittel, bei dem folgende Schritte ausgeführt werden:
a) ein elektrisches Gerät wird bereitgestellt, das mit mehreren Komponenten vormontiert ist, die schraubenlose Anschlußstellen nach der Draht-Einstecktechnik aufweisen,
b) durch Relativbewegung zwischen dem vormontierten Gerät und den Leitungsverlegemitteln wird eine erste Anschlußstelle in den Arbeitsbereich der Leitungsverlegemittel gebracht und relativ zu diesen lagegerecht positioniert,
c) mittels der Leitungsverlegemittel wird ein zuvor von seiner Isolierumhüllung freigeschnittenes erstes Ende einer diesen endlos zugeführten Leitung in Leitungslängsrichtung in eine Kontaktierzone der ersten Anschlußstelle eingeführt und dadurch selbsttätig kontaktgebend mechanisch dort fixiert,
d) durch eine weitere Relativbewegung entlang einer vorgegebenen Bahn zwischen der ersten Anschlußstelle und den Leitungsverlegemitteln wird unter Verlegung der Leitung eine zweite Anschlußstelle in den Arbeitsbereich der Leitungsverlegemittel gebracht und relativ zu diesen lagerichtig positioniert, wobei während dieser Relativbewegung die Leitungsverlegemittel zumindest eine dem Leitungsverlegeweg zwischen der ersten und der zweiten Anschlußstelle entsprechende Länge der ihnen endlos zugeführten Leitung ausgeben, die so groß bemessen ist, daß die zwischen den Anschlußstellen verlegte Leitung im wesentlichen zugspannungsfrei ist,
e) die Leitung wird in einem zuvor von der Isolierumhüllung freigeschnittenen Bereich zur Bildung eines abisolierten Einsteckendes für die zweite Anschlußstelle und zur gleichzeitigen Bildung eines weiteren abisolierten Einsteckendes für die nachfolgende Anschlußstelle durchtrennt,
f) mittels der Leitungsverlegemittel wird das erste dieser Leiter-Einsteckenden gefaßt und in seiner Längsrichtung in die Kontaktierzone der zweiten Anschlußstelle eingeführt und dabei kontaktgebend selbsttätig mechanisch fixiert,
g) das mit dem Durchtrennen bereitgestellte weitere Leiter-Einsteckende wird von den Leitungsverlegemitteln gefaßt, und die Verfahrensschritte b bis f werden so oft nacheinander ausgeführt, bis alle gewünschten Leitungsanschlüsse an den Anschlußstellen der Komponenten des elektrischen Geräts vollzogen sind.

2. Verfahren nach Anspruch 1, dadurch gekennzeichnet, daß man die Leitungsverlegemittel mittels eines mehrachsig, insbesondere sechsachsig, programmgesteuerten Industrieroboters bewegt.

3. Verfahren nach Anspruch 1 oder 2, dadurch gekennzeichnet, daß während der Relativbewegung der Leitungsverlegemittel und der in entsprechender Länge ausgegebenen Leitung bei deren Verlegung gegenüber dem Verfahrweg der Leitungsverlegemittel eine Leitungs-Mehrlänge ausgegeben wird, die etwa der Weglänge entspricht, die das Leitungsverlegemittel zurücklegt, um nach Ergreifen des Leiters dessen abisoliertes Ende in die Anschlußstelle einzustecken.

4. Verfahren nach einem der vorhergehenden Ansprüche, dadurch gekennzeichnet, daß man das - programmgesteuerte - Freischneiden der Isolierumhüllung der Leitung dem Verlegen der Leitung derart vorschaltet, daß die Verlegemittel mit den bereits in vorberechneten Abständen freigeschnittenen Endlos-Leitungen versorgt werden.

5. Verfahren nach Anspruch 4, dadurch gekennzeichnet, daß das Freischneiden der Leitung ihrem Verlegen unter Zwischenschaltung einer Leitungs-Pufferung vorgelagert ist, 10, daß das Verlegen der Leitung vom Freischneiden ihrer Isolierumhüllung unbeeinträchtigt erfolgen kann.

6. Verfahren nach Anspruch 1 oder einem der darauf folgenden, dadurch gekennzeichnet, daß bei jedem Einstecken der Leitung in eine Anschlußstelle die dabei auftretenden Kräfte gemessen und mit wenigstens einem einstellbaren Schwellwert verglichen werden, wobei das Überschreiten des Schwellwertes wie auch ggf. das Unterschreiten eines zweiten Schwellwerts ein Fehlersignal auslöst.

7. Verfahren nach Anspruch 1 oder einem der darauf folgenden, dadurch gekennzeichnet, daß die Leitung nach dem Einstecken in eine Anschlußstelle, insbesondere kurzzeitig, zugbelastet wird und die dabei auftretenden Kräfte gemessen und mit einem einstellbaren Schwellwert verglichen werden, dessen Unterschreiten ein Fehlersignal auslöst.

8. Verfahren nach einem der vorherigen Ansprüche, dadurch gekennzeichnet, daß man die leitungsspendenden Verlegemittel zeitweise aus dem unmittelbaren Arbeitsbereich der Mittel zum Ergreifen des in eine Anschlußstelle einzusteckenden Leiterendes entfernt.

9. Vorrichtung zum Verdrahten von Anschlußstellen von Komponenten elektrischer Geräte, insbesondere zur Durchführung des Verfahrens nach einem der vorhergehenden Ansprüche, mit einem Leitungs-Verlegewerkzeug, das eine Leitungszuführung (29) für die einem Vorrat (11) endlos entnommene Leitung (12), ein der Mündungsseite der Leitungszuführung vorgelagertes bewegliches Messer (41) zum Durchtrennen der Leitung sowie ein Manipulationsglied (31) zum Anbringen der Leitung an eine Anschlußstelle der jeweiligen Komponente (37,39) umfaßt, dadurch gekennzeichnet, daß das Manipulationsglied als Greifer (31) mit öffen- und schließbaren Greiferbacken (31a, 31b) zum - programmgesteuert intermittierenden - Erfassen der Leitung (12) ausgebildet und der Mündung (30) der Leitungszuführung (29) so zugeordnet ist, daß die Leitung (12) selbsttätig zwischen die geöffneten Greiferbacken (31a, 31b) einführbar ist.

10. Vorrichtung nach Anspruch 9, dadurch gekennzeichnet, daß der Greifer (31) auf der der Mündung (30) der Leitungszuführung (29) abgewandten Seite des Messers (41) angeordnet ist.

11. Vorrichtung nach Anspruch 9 oder 10, dadurch gekennzeichnet, daß Leitungszuführung (29) und Greifer (31) relativ zueinander verstellbar angeordnet sind, insbesondere derart, daß die Leitungszuführung (29) vorübergehend aus dem ein Leitungsende manipulierenden Arbeitsbereich des Greifers (31) entfernbar ist.

12. Vorrichtung nach Anspruch 11, dadurch gekennzeichnet, daß Leitungszuführung (29), Antrieb (26) und Messer (41) zu einer Baugruppe zusammengefaßt sind, die relativ zum Manipulierwerkzeug (31) verstellbar angeordnet ist.

13. Vorrichtung nach einem der Ansprüche 9 bis 12, dadurch gekennzeichnet, daß die Greiferbacken (31a, 31b) des Greifers (31) in eine Stellung bringbar sind, die eine kraftfreie Relativbewegung zur Leitung (12) gewährleistet, zugleich jedoch die Leitung (12) gegen Herausfallen aus dem Greiferbereich sichert.

14. Vorrichtung nach einem der Ansprüche 9 bis 13, dadurch gekennzeichnet, daß der Greifer (31) an eine Kraftmeßeinrichtung (35) wie Kraftmeßdose angeschlossen ist, die Belastungskräfte des Greifers (31) in beiden Längsrichtungen der von ihm ergriffenen Leitung (12) mißt.

15. Vorrichtung nach einem der Ansprüche 9 bis 14, dadurch gekennzeichnet, daß zwischen dem Vorrat (11) für die Leitung (12) und dem Verlegewerkzeug (25) eine Freischneideinrichtung (14) angeordnet ist, die die Isolierumhüllung (17) der Leitung (12) auf einer Länge vom blanken Draht entfernt, die möglichst exakt dem Zweifachen der Länge eines für einen ordnungsgemäßen elektrischen sowie mechanisch sicheren Steckanschluß erforderlichen abisolierten Leitungsendes (36; 42) entspricht.

16. Vorrichtung nach einem der Ansprüche 9 bis 15, dadurch gekennzeichnet, daß zwischen der Freischneideinrichtung (14) und dem Verlegewerkzeug (25) ein Leitungskompensator (21) vorgesehen ist, der einen Leitungspuffer bzw. -speicher schafft, damit Freischneideinrichtung (14) und Verlegewerkzeug (25) unabhängig voneinander, insbesondere in unterschiedlichen Takten arbeiten können.

17. Vorrichtung nach Anspruch 16, dadurch gekennzeichnet, daß der Freischeindeinrichtung (14) und dem Leitungskompensator (21) jeweils ein Antrieb (19, 24) zum Vorschub der Leitung (12) nachgeordnet ist, wobei der Leitungskompensator (21) mindestens auf den ersten Antrieb (19) Steuerbefehle zur Beschleunigung oder Verlangsamung des Leitungsvorschubs übermittelt.

18. Vorrichtung nach einem der Ansprüche 9 bis 17, dadurch gekennzeichnet, daß ein dritter Antrieb (26) zum Leitungsvorschub dem Verlegewerkzeug (25) zugeordnet und mit dem Antrieb (24) hinter dem Kompensator (21) derart sychronisiert ist, daß die Leitung (12) insgesamt im wesentlichen spannungsfrei gehalten ist.

19. Vorrichtung nach einem der Ansprüche 9 bis 18 mit zusätzlich zu den Komponenten (38, 39) am Gerät verlegten Leitungshaltern (45), dadurch gekennzeichnet, daß die Leitungshalter (45) als Klammern mit die Leitung (12) um- und übergreifenden Federschenkeln (47) ausgebildet sind, die vom Verlegewerkzeug (25) selbst bei dessen Bewegung während der Leitungsverlegung zur Leitungseinbringung in den Halter (45) vorübergehend öffenbar sind.

## Claims

1. Method of wiring connecting points of electrical components with the aid of controlled line installation means, wherein the following steps are executed:
a) an electrical appliance is provided, which has been preassembled with a plurality of components having screwless connecting points in accordance with the wire insertion technique,
b) through relative movement between the preassembled appliance and the line installation means a first connecting point is brought into the working range of the line installation means and positioned correctly relative to the latter,
c) by means of the line installation means a first end, which has been previously stripped of its insulation enclosure, of a line fed continuously to said line installation means is introduced in line longitudinal direction into a contacting zone of the first connecting point and therefore automatically mechanically fixed there in a contacting manner,
d) through a further relative movement along a preset path between the first connecting point and the line installation means and while simultaneously installing the line a second connecting point is brought into the working range of the line installation means and positioned correctly relative to the latter, the line installation means during said relative movement dispensing at least a length of the line fed continuously to them, which corresponds to the line installation distance between the first and the second connecting point and is great enough for the line installed between the connecting points to be substantially free of tensile stress,
e) the line is cut in a region previously stripped of the insulation enclosure to form a bared insertion end for the second connecting point and simultaneously form a further bared insertion end for the next connecting point,
f) by means of the line installation means the first of said conductor insertion ends is grasped and introduced in its longitudinal direction into the contacting zone of the second connecting point and in the process is automatically mechanically fixed in a contacting manner,
g) the further conductor insertion end provided by the cutting operation is grasped by the line installation means, and the process steps b to f are successively repeated until all of the required line connections to the connecting points of the components of the electrical appliance have been completed.

2. Method according to claim 1, characterized in that the line installation means are moved by means of a multi-axis, in particular six-axis, program-controlled industrial robot.

3. Method according to claim 1 or 2, characterized in that, during the relative movement of the line installation means and of the line dispensed in an appropriate length during its installation, a - compared to the travel distance of the line installation means - line overlength is dispensed, which corresponds approximately to the distance which the line installation means travels in order, after grasping of the conductor, to insert the bared end of the latter into the connecting point.

4. Method according to one of the preceding claims, characterized in that the - program-controlled - stripping of the insulation enclosure of the line is effected prior to the installation of the line in such a way that the installation means are supplied with the continuous lines already stripped at precalculated intervals.

5. Method according to claim 4, characterized in that the stripping of the line is effected prior to its installation, a line buffer being provided between said two operations so that installation of the line may be effected without being impaired by the stripping of its insulation enclosure.

6. Method according to claim 1 or one of the claims following claim 1, characterized in that, upon each insertion of the line into a connecting point, the forces then arising are measured and compared with at least one adjustable threshold value, a fault signal being triggered when said forces exceed the threshold value as well as optionally fall below a second threshold value.

7. Method according to claim 1 or one of the claims following claim 1, characterized in that the line after being inserted into a connecting point is subjected, in particular briefly, to a tensile load and the forces then arising are measured and compared with an adjustable threshold value, a fault signal being triggered when said forces are lower than the threshold value.

8. Method according to one of the previous claims, characterized in that the line-dispensing installation means are temporarily removed from the immediate working range of the means of grasping the conductor end which is to be inserted into a connecting point.

9. Apparatus for wiring connecting points of components of electrical appliances, in particular for effecting the method according to one of the preceding claims, having a line installation tool, which comprises a line feed (29) for the line (12) continuously removed from a supply (11), a movable blade (41) disposed in front of the mouth end of the line feed for cutting the line, as well as a manipulation element (31) for bringing the line up to a connecting point of the respective component (37, 39), characterized in that the manipulation element takes the form of a gripper (31) having openable and closable gripper jaws (31a, 31b) for the - program-controlled intermittent - grasping of the line (12) and is associated with the mouth (30) of the line feed (29) in such a way that the line (12) may be automatically introduced between the opened gripper jaws (31a, 31b).

10. Apparatus according to claim 9, characterized in that the gripper (31) is disposed at the side of the blade (41) remote from the mouth (30) of the line feed (29).

11. Apparatus according to claim 9 or 10, characterized in that line feed (29) and gripper (31) are disposed so as to be displaceable relative to one another, in particular in such a way that the line feed (29) is temporarily removable from the working range of the gripper (31) manipulating a line end.

12. Apparatus according to claim 11, characterized in that line feed (29), drive (26) and blade (41) are combined into a subassembly, which is disposed so as to be displaceable relative to the manipulating tool (31).

13. Apparatus according to one of claims 9 to 12, characterized in that the gripper jaws (31a, 31b) of the gripper (31) are movable into a position, which guarantees a force-free movement relative to the line (12) but at the same time prevents the line (12) from falling out of the gripper region.

14. Apparatus according to one of claims 9 to 13, characterized in that the gripper (31) is connected to a force-measuring device (35) such as a load cell, which measures the loading forces of the gripper (31) in both longitudinal directions of the line (12) grasped by the gripper.

15. Apparatus according to one of claims 9 to 14, characterized in that disposed between the supply (11) for the line (12) and the installation tool (25) is a stripping device (14), which removes the insulation enclosure (17) of the line (12) to produce a length of bare wire which corresponds as precisely as possible to twice the length of a bared line end (36; 42) required for a correct, electrical and mechanically secure push-lock connection.

16. Apparatus according to one of claims 9 to 15, characterized in that provided between the stripping device (14) and the installation tool (25) is a line compensator (21), which creates a line buffer or store so that stripping device (14) and installation tool (25) may operate independently of one another, in particular in different cycles.

17. Apparatus according to claim 16, characterized in that disposed downstream of the stripping device (14) and the line compensator (21) is in each case a drive (19, 24) for forward feed of the line (12), the line compensator (21) communicating control commands at least to the first drive (19) for speeding up or slowing down the forward feed of the line.

18. Apparatus according to one of claims 9 to 17, characterized in that a third drive (26) for forward feed of the line is associated with the installation tool (25) and synchronized with the drive (24) downstream of the compensator (21) in such a way that the line (12) as a whole is kept substantially stress-free.

19. Apparatus according to one of claims 9 to 18 having line holders (45) installed in addition to the components (37, 39) on the appliance, characterized in that the line holders (45) take the form of brackets having spring limbs (47), which engage around and over the line (12) and are temporarily openable by the installation tool (25) itself upon the latter's movement during line installation for introducing the line into the holder (45).

## Revendications

1. Procédé pour câbler les points de raccordement de composants électriques, à l'aide de moyens de pose de lignes électriques commandés, dans lequel sont effectuées les étapes ci-après :
a) un appareil électrique est préparé, qui est prémonté avec plusieurs composants, présentant des points de raccordement sans vis, réalisés selon la technique à enfichage de fil,
b) par un déplacement relatif entre l'appareil prémonté et les moyens de pose de l'unité électrique, un premier point de raccordement est placé dans la zone de travail des moyens de pose de ligne électrique et est positionné en situation correcte vis-à-vis de ceux-ci,
c) à l'aide des moyens de pose de ligne électrique, on introduit une première extrémité, ayant été dénudée préalablement de sa gaine isolante, d'une ligne électrique amenée à ceux-ci de façon continue dans la direction longitudinale de la ligne, dans une zone de contact du premier point de raccordement, et on fixe de ce fait à cet endroit par voie mécanique, en établissant automatiquement le contact,
d) par un autre déplacement relatif, le long d'une trajectoire prédéterminée, entre le premier point de raccordement et les moyens de pose de ligne électrique, en posant la ligne électrique, on place un deuxième point de raccordement dans la zone de travail des moyens de pose de ligne électrique, et on assure le positionnement relatif en position correcte par rapport à ceux-ci, où pendant ce déplacement relatif, les moyens de pose de ligne électrique fournissent au moins une première longueur, correspondant à la course de pose de ligne électrique entre le premier et le deuxième point de raccordement, de la ligne électrique leur étant amenée de façon continue, longueur telle que la ligne électrique posée entre les points de raccordement est pratiquement exempte de contrainte de traction,
e) la ligne électrique, dans une zone débarrassée préalablement du gainage d'isolation, est coupée pour constituer une extrémité d'enfichage dénudée, pour le deuxième point de raccordement, et pour former simultanément une autre extrémité à enfichage dénudée, prévue pour le point de raccordement subséquent,
f) à l'aide des moyens de ligne électrique, la première de ces extrémités d'enfichagse de ligne électrique est saisie et est insérée dans sa direction longitudinale dans la zone de contact du deuxième point de raccordement, et fixée de façon mécanique, en établissant alors automatiquement le contact,
g) l'extrémité d'enfichage de ligne électrique supplémentaire, préparée par l'opération de découpage de séparation, est saisie par les moyens de pose de ligne électrique, et les étapes de procédé b à f sont effectuées les unes après les autres, aussi fréquemment que ce qui est nécessaire pour que tous les raccordements de ligne électrique souhaités soient effectués aux points de raccordement des composants de l'appareil électrique.

2. Procédé selon la revendication 1, caractérisé en ce qu'on déplace les moyens de pose de ligne électrique à l'aide d'un robot industriel à plusieurs axes, en particulier à six axes, placé sous la commande d'un programme.

3. Procédé selon la revendication 1 ou 2, caractérisé en ce que, pendant le déplacement relatif des moyens de pose de ligne électrique et de la ligne sortant en longueur correspondante, lors de sa pose, par rapport à la course de déplacement des moyens de pose de ligne électrique, est extraite une surlongueur de ligne électrique qui correspond à peu près à la longueur de course que parcourent les moyens de pose de ligne électrique pour procéder à l'enfichage dans le point de raccordement de l'extrémité dénudée du conducteur, après sa saisie.

4. Procédé selon l'une des revendications précédentes, caractérisé en ce qu'on planifie le découpage - commandé par un programme - de la gaine isolante de la ligne électrique avant la pose de la ligne électrique, de manière que les moyens de pose soient alimentés avec les lignes électriques continues, découpées déjà à des espacements précalculés.

5. Procédé selon la revendication 4, caractérisé en ce que le découpage de la ligne est effectué avant sa pose avec interposition d'un élément tampon de ligne, de manière que la pose de la ligne électrique puisse s'effectuer sans être entravée par l'opération de découpage de sa gaine isolante.

6. Procédé selon la revendication 1 ou l'une des revendications suivantes, caractérisé en ce qu'à chaque enfichage de la ligne électrique dans un point de raccordement, les efforts se produisant alors sont mesurés et sont comparés à au moins une valeur de seuil réglable, le dépassement de la valeur de seuil ainsi qu'également la descente au-dessous d'une deuxième valeur de seuil déclenchant un signal de défaut.

7. Procédé selon la revendication 1 ou l'une des revendications suivantes, caractérisé en ce que la ligne, après enfichage dans un point de raccordement, est soumise à une traction, en particulier de façon brève, et les efforts se produisant alors sont mesurés et comparés à une valeur de seuil réglable, dont la descente au-dessous de cette valeur déclenche un signal de défaut.

8. Procédé selon l'une des revendications précédentes, caractérisé en ce qu'on éloigne par moments les moyens de pose assurant la fourniture en ligne électrique hors de la zone de travail directe des moyens de saisie de l'extrémité de ligne électrique à enficher dans un point de raccordement.

9. Dispositif pour câbler des points de raccordement appartenant à des composants d'appareils électriques, en particulier pour mettre en oeuvre le procédé selon l'une des revendications précédentes, avec un outil de pose de ligne électrique (29) qui comprend une alimentation en ligne électrique (29) pour la ligne électrique (12) prélevée de façon continue d'une réserve (11), une lame (41) mobile placée à l'avant du côté embouchure de l'amenée de ligne, pour assurer le découpage de séparation de la ligne, ainsi qu'un organe de manipulation (31) destiné à monter la ligne en un point de raccordement des composants (37-39) respectifs, caractérisé en ce que l'organe de manipulation est réalisé sous la forme d'un organe de préhension (31) équipé avec des mâchoires de préhension (31a, 31b) susceptibles d'être ouvertes et fermées, afin de saisir - de façon intermittente et sous la commande d'un programme - la ligne électrique (12) et est associé à l'embouchure (30) de l'amenée en ligne électrique, de manière que la ligne électrique (12) puisse être introduite automatiquement entre les mâchoires de préhension (31a, 31b) ouvertes.

10. Dispositif selon la revendication 9, caractérisé en ce que l'organe de préhension (31) est disposé sur le côté de la lame (41) opposé à l'embouchure (30) de l'amenée de ligne électrique (29).

11. Dispositif selon la revendication 9 ou 10, caractérisé en ce que l'alimentation en ligne électrique (29) et les organes de préhension (31) sont disposés de façon à être réglables les uns par rapport aux autres, en particulier de manière que l'alimentation en ligne électrique (29) puisse être provisoirement éloignée hors de la zone de travail de l'organe de préhension (31), où s'effectue une manipulation d'une extrémité de ligne électrique.

12. Dispositif selon la revendication 11, caractérisé en ce que l'alimentation en ligne électrique (29), l'entraînement (26) et la lame (41) sont assemblés un groupe de construction disposé réglable par rapport à l'outil de manipulation (31).

13. Dispositif selon l'une des revendications 9 à 12, caractérisé en ce que les mâchoires de préhension (31a, 31b) de l'organe de préhension (31) peuvent être placées dans une position assurant un déplacement relatif sans effort vis-à-vis de la ligne électrique (12), tout en assurant simultanément cependant la ligne électrique (12) contre toute chute par sortie de la zone de préhension.

14. Dispositif selon l'une des revendications 9 à 13, caractérisé en ce que l'organe de préhension (31) est raccordé à un dispositif dynamométrique (35), tel qu'une jauge dynamométrique, qui mesure les efforts de sollicitation de l'organe de préhension (31), dans les deux directions longitudinales de la ligne électrique (12) saisie par lui.

15. Dispositif selon l'une des revendications 9 à 14, caractérisé en ce que, entre la réserve (11) en ligne électrique (12) et l'outil de pose (25), est disposé un dispositif de découpage (14) qui enlève le gainage isolant (17) de la ligne électrique (12) sur une longueur de fil nu, qui correspond de façon aussi exacte que possible au double de la longueur d'une extrémité de ligne électrique (36; 42) ayant été dénudée, nécessaire pour obtenir un raccordement par enfichage conforme, offrant une sécurité tant électrique que mécanique.

16. Dispositif selon l'une des revendications 9 à 15, caractérisé en ce que, entre le dispositif de découpage (14) et l'outil de pose (25), est prévu un compensateur de ligne électrique (21) qui crée un tampon ou un stockage de ligne électrique, afin que le dispositif de découpage (14) et l'outil de pose (25) puissent travailler indépendamment l'un de l'autre, en particulier à des cadences différentes.

17. Dispositif selon la revendication 16, caractérisé en ce qu'en aval du dispositif de découpage (14) et du compensateur de ligne électrique (21), est respectivement disposé un entraînement (19, 24) destiné à assurer l'avancement de la ligne électrique (12), le compensateur de ligne (21) transmettant, au moins au premier entraînement (19), des ordres de commande destinés à obtenir l'accélération ou le ralentissement de l'avancement de la ligne électrique.

18. Dispositif selon l'une des revendications 9 à 17, caractérisé en ce qu'un troisième entraînement (26), destiné à l'avancement de la ligne, est associé à l'outil de pose (25) et est synchronisé avec l'entraînement (24) placé derrière le compensateur (21), de manière que la ligne électrique (12) soit globalement maintenue pratiquement sans contrainte ou tension.

19. Dispositif selon l'une des revendications 9 à 18, comportant, en plus des composants (38, 39), des supports de ligne (45) posés sur l'appareil, caractérisé en ce que les supports de ligne (45) sont réalisés sous la forme de pinces avec des branches de ressort (47) saisissant par le pourtour et le dessus la ligne électrique (12), les branches étant susceptibles d'être ouvertes temporellement par l'outil de pose (25) lui-même, lors de son déplacement pendant la pose de la ligne, afin d'introduire la ligne dans le support (45).
